Europäisches Patentamt

(19) European Patent Office · (11) Veröffentlichungsnummer: **0 062 725**

Office européen des brevets **B1**

(12) **EUROPÄISCHE PATENTSCHRIFT**

(45) Veröffentlichungstag der Patentschrift: (51) Int. Cl.³: **H 01 L 21/225**
**12.09.84**

(21) Anmeldenummer: **81710017.5**

(22) Anmeldetag: **14.04.81**

(54) **Verfahren zum Herstellen eines integrierten Planartransistors.**

(43) Veröffentlichungstag der Anmeldung:
**20.10.82 Patentblatt 82/42**

(45) Bekanntmachung des Hinweises auf die Patenterteilung:
**12.09.84 Patentblatt 84/37**

(84) Benannte Vertragsstaaten:
**DE FR GB IT NL**

(56) Entgegenhaltungen:
**US - A - 3 756 861**

**IBM TECHNICAL DISCLOSURE BULLETIN, Band 23, Nr. 2, Juli 1980, Seite 644 New York, U.S.A. M. BRISKA et al.: "Method for producing arsenic-implanted emitters without crystal defects"**

(73) Patentinhaber: **Deutsche ITT Industries GmbH, Hans-Bunte-Strasse 19 Postfach 840, D-7800 Freiburg (DE)**
(84) Benannte Vertragsstaaten: **DE**

(73) Patentinhaber: **ITT INDUSTRIES, INC., 320 Park Avenue, New York, NY 10022 (US)**
(84) Benannte Vertragsstaaten: **FR GB IT NL**

(72) Erfinder: **Gahle, Hans-Jürgen, Dr. Ing., Panoramastrasse 13, D-7830 Emmendingen (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

## Beschreibung

Die Erfindung beschäftigt sich mit der Herstellung von integrierten Planartransistoren kleinster Abmessungen, wie sie in bipolaren integrierten Schaltungen hoher Packungsdichte Verwendung finden. Dabei wird ausgegangen von dem aus der DE-OS Nr. 3009434 und aus der Zeitschrift „Electronics" vom 7. 8. 1975, Seiten 104 bis 106, bekannten Dreifach-Diffusionsverfahren (3D-Technologie). Dieses Verfahren zeichnet sich dadurch aus, dass nacheinander in drei Prozessen mittels Ionenimplantation die Dotierungen der Kollektorzone, der Basiszone und der Emitterzone aufgebracht und eindiffundiert werden, so dass drei Diffusionsprozesse aufeinanderfolgen.

Dieses im folgenden als 3D-Verfahren bezeichnete Verfahren hat, abgesehen von der Möglichkeit einer Herstellung von bipolaren integrierten Schaltungen hoher Packungsdichte, den Vorteil, dass die Hochtemperaturprozesse des Aufbringens einer Epitaxialschicht auf eine, gegebenenfalls mit Dotierungsbereichen zur Herstellung von vergrabenen Schichten versehenen Substrats und die Diffusion von Isolationszonen entfallen. Diese zur elektrischen Trennung der einzelnen Transistoren im allgemeinen erforderlichen Hochtemperaturprozesse werden beim 3D-Verfahren durch einen Hochtemperaturprozess, nämlich den Kollektordiffusionsprozess, ersetzt. Es entstehen schliesslich Planartransistoren mit ineinander diffundierten Zonen.

Die Erfindung betrifft somit ein Verfahren gemäss dem Oberbegriff des Anspruchs 1, wie es aus den obengenannten Veröffentlichungen bekannt ist.

Aufgabe der Erfindung ist die Herstellung von Planartransistoren, deren drei Zonen in nur zwei Hochtemperaturprozessen hergestellt werden, so dass sehr geringe Diffusionstiefen möglich sind.

Diese Aufgabe wird erfindungsgemäss durch die im kennzeichnenden Teil des Anspruchs 1 angegebenen Massnahmen gelöst.

Beim Verfahren nach der Erfindung, welches somit als 2D-Verfahren bezeichnet werden kann, findet abgesehen vom Hochtemperaturprozess der Kollektordiffusion also erst ein einziger Hochtemperaturprozess statt, nachdem die Dotierungen sowohl der Basiszone als auch der Emitterzone in die Halbleiterfläche eingebracht worden sind.

Vorzugsweise werden ausschliesslich Photolackmasken zur Begrenzung der Ionenimplantation verwendet, da deren Herstellung keine hohen Temperaturen erfordert, wie es bei der Herstellung von Oxidmasken zum gleichen Zweck erforderlich wäre.

In Weiterbildung des Verfahrens nach der Erfindung werden das Dotierungsmaterial der Basiszone und das der Emitterzone durch dieselbe Oxidschicht implantiert, welche in gesteuerter Weise bei der Diffusion der Kollektorzone hergestellt wird. Dabei ergibt sich der Vorteil, dass die Auswirkungen von Dickenschwankungen der bei der Kollektordiffusion entstehenden Oxidschicht auf die Basiszonendickenschwankungen unter der Emitterzone kompensiert werden, da diese Oxiddickenschwankungen in gleicher Weise auf die Implantationsprozesse zur Einbringung der Dotierungen sowohl der Emitterzone als auch der Basiszone sich auswirken.

Der Hochtemperaturprozess zur Aktivierung der Dotierungen der Basiszone und der der Emitterzone unter der schützenden Fremdisolierschicht hat im Falle der Verwendung eines Fremdoxids ($SiO_2$) den Vorteil, dass das dadurch verfestigte $SiO_2$ erst ätzbar wird. Diese Verfestigung führt soweit, dass selbst mit einem Nass-Ätzverfahren zur Anbringung von Kontaktierungsöffnungen praktisch die gleiche Ätzzeit benötigt wird, wie sie bei einer thermisch aus dem Halbleitermaterial erzeugten Passivierungsschicht erforderlich wäre.

Das Verfahren der Erfindung wird im folgenden an einem Ausführungsbeispiel anhand der Zeichnung erläutert, deren Figuren in üblicher Querschnittsansicht etwa senkrecht zu einer Halbleiterplatte den Ausschnitt einer monolithisch integrierten Festkörperschaltung zeigen und die zur Erläuterung der aufeinanderfolgenden Prozessstadien des Verfahrens nach der Erfindung dienen.

Der plattenförmige Halbleiterkörper 2 enthält üblicherweise eine Vielzahl von Festkörperschaltungen mit einer Vielzahl von integrierten Planartransistoren und wird nach deren Fertigstellung und Kontaktierung in die einzelnen Festkörperschaltungen zerteilt.

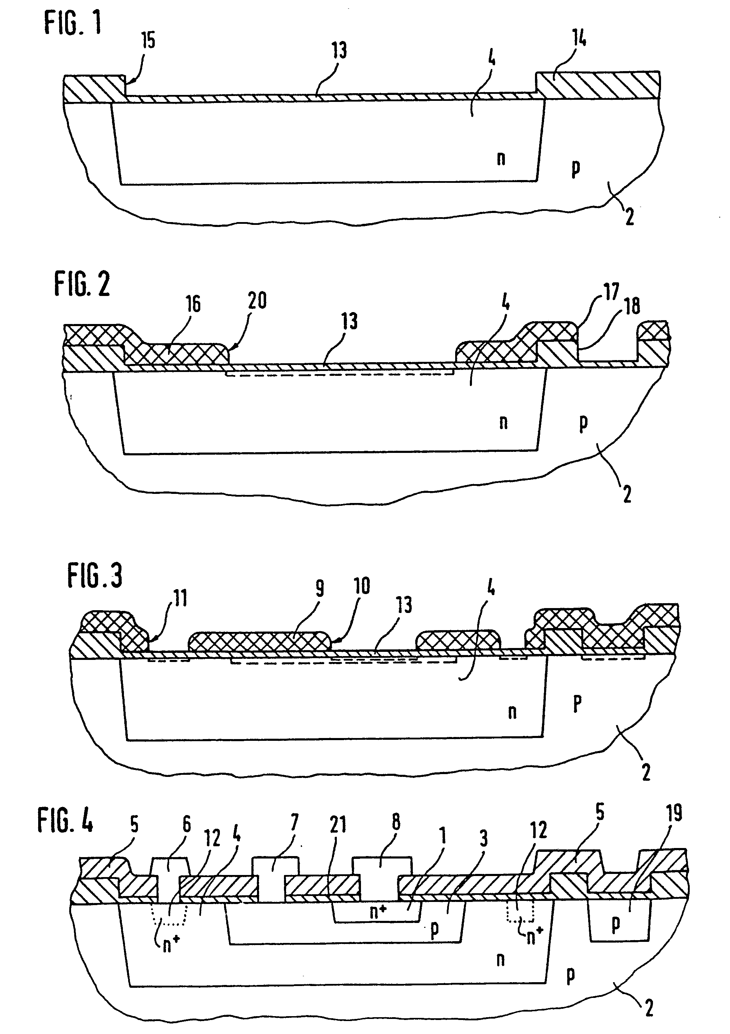

Beim Verfahren nach der Erfindung wird von einer Anordnung ausgegangen, wie sie im Schnitt in der Fig. 1 dargestellt ist. Die Fig. 1 veranschaulicht einen p-dotierten plattenförmigen Halbleiterkörper 2, in den unter Verwendung einer Oxidmaskierungsschicht 14 die n-dotierte Kollektorzone 4 in oxidierender Atmosphäre eindiffundiert wurde, wobei sich die Oxidschicht 13 ausbildete. Zu diesem Zwecke kann das bekannte Planardiffusionsverfahren angewendet werden. Da aber die benötigten geringen Dotierungsmengen praktisch nur mit Ionenimplantation beherrschbar sind, wird es vorgezogen, das Dotierungsmaterial unter Verwendung der Oxidmaskierungsschicht 14 oder auch eine Photolackmaske als Maske in die Halbleiteroberfläche zu implantieren und anschliessend die Dotierungen während eines anschliessenden Diffusionsprozesses in oxidierender Atmosphäre zu aktivieren. Als Dotierungsmaterial der Kollektorzone 4 kann Phosphor verwendet werden.

Es ist von grossem Vorteil, innerhalb der Maskierungsöffnung 15 in der Oxidmaskierungsschicht 14 eine Oxidschicht 13 solcher Dicke zu erzeugen, dass das Dotierungsmaterial der Basiszone 3 durch dieselbe Oxidschicht 13 wie das der Emitterzone 1 implantiert werden kann. Dies hat den Vorteil, dass die Auswirkungen von Schichtdickenschwankungen der Oxidschicht 13 auf die Basiszonendickenschwankungen unter der Emitterzone 1 vermindert sind. Wird eine Oxidschicht 13 in einer Dicke zwischen 30 und 60 nm erzeugt, dann kann sowohl Bor als Dotierungsmaterial der Basiszone 3 als auch Arsen als Dotierungsmaterial der Emitterzone 1 durch dieselbe Oxidschicht 13 implantiert werden.

Nach der Erzeugung der Kollektorzone 4 und der Oxidschicht 13 kann in der Oxidmaskierung 14 eine die Kollektorzone 4 umgebende rahmenförmige Öffnung 18 angebracht werden, durch die während der Implantation der Dotierungen der Basiszone 3 die Dotierungen einer Schutzringzone 19 (vgl. Fig. 4) implantiert werden.

Nach Aufbringen der Maskierungsschicht 16, insbesondere aus einem Photolack, mit der rahmenförmigen Implantationsöffnung 17 und der Basisimplantationsöffnung 20 werden Borionen gemäss der Fig. 2 implantiert. Anschliessend wird die Maskierungsschicht 16 entfernt.

Anschliessend wird die Implantationsmaske 9 mit einer die Emitterzonenimplantationsöffnung 10 rahmenförmig umgebenden Öffnung 11, welche zur Implantation des Dotierungsmaterials einer rahmenförmigen Kollektorkontaktierungszone 12 (vgl. Fig. 4) dient, aufgebracht. Es erfolgt nun die Implantation von Arsenionen.

Bei einer Dicke der Oxidschicht 13 im erwähnten Bereich zwischen 30 und 60 nm sind Beschleunigungsspannungen von ca. 200 KV für die Arsenatome erforderlich. Werden anstelle von Arsenionen Phosphorionen implantiert, so ist bereits eine Beschleunigungsspannung von 100 KV ausreichend, da das Phosphorion kleiner ist als das Arsenion. Es wird jedoch Arsen als Dotierung der Emitterzone vorgezogen, da Arsen sich besser in das Si-Gitter einbaut und sich deshalb bessere elektrische Eigenschaften der Bauelemente ergeben.

Nach sorgfältiger Entfernung der Implantationsmaske 9 wird entsprechend dem Verfahren der Erfindung die Oberflächenseite des Halbleiterkörpers 2 mit einer Fremdisolierschicht 5, vorzugsweise aus $SiO_2$, bedeckt und anschliessend die implantierten Ionen während einer Temperung unter gleichzeitiger Ausbildung der Basiszone 3 und der Emitterzone 4 aktiviert. Dabei entstehen die Kollektorkontaktierungszone 12 und die Schutzringzone 19. Ferner wird die Fremdisolierschicht 5 verfestigt.

Wie die Fig. 4 veranschaulicht, werden nun in der Fremdisolierschicht 5 Kontaktfenster hergestellt und die Kontakte 6, 7 und 8 angebracht. Dabei ist von Vorteil, dass die Ränder des Emitter-PN-Übergangs 21 währnd des gesamten Hochtemperaturprozesses geschützt sind und danach auch bleiben, so dass Emitter mit reproduzierbar hohen Emitterergibigkeiten bis zu vergleichsweise sehr niedrigen Stromdichten erhalten werden.

Die Grenzfrequenz ($f_D$) eines mit dem Verfahren nach der Erfindung hergestellten integrierten Planartransistors mit einer Fläche von 36 µm² liegt bei etwa 2 GHz., also wesentlich höher als bei dem nach dem Verfahren der DE-OS Nr. 3009434 hergestellten.

Bei dem beschriebenen Verfahren wurden ausschliesslich Photolackmasken zur Begrenzung der Ionenimplantation der Dotierungen der Basiszone 3 und der Emitterzone 1 verwendet.

## Patentansprüche

1. Verfahren zum Herstellen eines integrierten Planartransistors, dessen Emitterzone (1) an einer Oberflächenseite eines Halbleiterkörpers (2) in die Basiszone (3) und diese in die Kollektorzone (4) eindiffundiert sind, bei welchem Verfahren
   — mittels maskierter Ionenimplantationen die Dotierungen der Kollektorzone (4) in die Oberflächenseite eingebracht und in oxidierender Atmosphäre eindiffundiert werden, und
   — anschliessend die Dotierungen der Basiszone (3) sowie die der Emitterzone (1) mittels maskierter Ionenimplantation in die Oberfläche der Kollektorzone (4) eingebracht und eindiffundiert werden, dadurch gekennzeichnet,
   — dass nach der Diffusion der Kollektorzone (4) in oxidierender Atmosphäre nacheinander mittels maskierter Ionenimplantation die Dotierungen der Basiszone (3) und die der Emitterzone (1) in die Oberflächenseite eingebracht, das Maskierungsmaterial entfernt und die Oberflächenseite mit einer Fremdisolierschicht (5) bedeckt wird,
   — dass anschliessend die implantierten Ionen während einer Temperung unter gleichzeitiger Ausbildung der Basiszone (3) und der Emitterzone (1) aktiviert und die Fremdisolierschicht (5) verfestigt werden, und
   — dass schliesslich die Zonen (1, 3, 4) durch die Fremdisolierschicht (5) örtlich zur Anbringung von Kontakten (6, 7, 8) freigelegt werden.

2. Verfahren nach Anspruch 1, dadurch gekennzeichnet, dass die Diffusion der Kollektorzone (4) in einer solchen leicht oxidierenden Atmosphäre stattfindet, dass das Dotierungsmaterial der Basiszone (3) durch dieselbe Oxidschicht (13) wie das der Emitterzone (1) implantiert werden kann.

3. Verfahren nach einem der Ansprüche 1 oder 2, dadurch gekennzeichnet, dass das Dotierungsmaterial der Emitterzone (1) durch die Öffnungen einer Implantationsmaske (9) implantiert wird, welche neben der Emitterzonenimplantationsöffnung (10) eine diese rahmenförmig umgebende Öffnung (11) zur Implantation des Dotierungsmaterials einer rahmenförmigen Kollektorkontaktierungszone (12) aufweist.

4. Verfahren nach einem der Ansprüche 1 bis 3, dadurch gekennzeichnet, dass ausschliesslich Photolackmasken zur Begrenzung der Ionenimplantation der Dotierungen der Basiszone (3) und der Emitterzone (1) verwendet werden.

## Claims

1. Method of fabricating an integrated planar transistor whose emitter region (1) is diffused into the base region (3) on one surface side of a semiconductor wafer (2), which base region (3) is diffused into the collector region (4), wherein
   — the impurities of the collector region (4) are introduced into the surface side by masked ion implantation and diffused in an oxidizing atmosphere, and

— the impurities of the base region (3) and those of the emitter region (1) are then introduced into the surface of the collector region (4) by masked ion implantation and diffused, characterized in that

— after the diffusion of the collector region (4) in an oxidizing atmosphere, the impurities of the base region (3) and those of the emitter region (1) are sequentially introduced into the surface side by masked ion implantation, after which the mask material is removed and the surface side is covered with a protective insulating layer (5),

— the implanted ions are then activated in a tempering process, during which the base region (3) and the emitter region (1) are formed and during which the protective insulating layer (5) is solidified, and

— openings are finally formed in the protective insulating layer (5) through which contacts (6, 7, 8) can be deposited on the regions (1, 3, 4).

2. A method as claimed in claim 1, characterized in that the collector region (4) is diffused in such a slightly oxidizing atmosphere that the dopant of the base region (3) can be implanted through the same oxide layer (13) as that of the emitter region (1).

3. A method as claimed in one of claims 1 or 2, characterized in that the dopant of the emitter region (1) is implanted through the openings of an implantation mask (9) having, besides the emitter-region-implantation opening (10), a frame-shaped opening (11) surrounding the emitter-region-implantation opening (10) and serving to implant the dopant of a frame-shaped collector contact region (12).

4. A method as claimed in any one of claims 1 to 3, characterized in that exclusively photoresist masks are used during ion implantation into the base region (3) and the emitter region (1).

**Revendications**

1. Procédé de fabrication d'un transistor planar intégré dont la zone d'émetteur (1) est diffusée par l'une des faces d'un corps semi-conducteur (2), dans la zone de base (3), laquelle est diffusée dans la zone de collecteur (4), procédé dans lequel:

— les dopants de la zone de collecteur (4) sont introduits à travers ladite face par implantation ionique sous masquage et sont diffusés en atmosphère oxydante, et

— à la suite de cela, les dopants de la zone de base (3) et de la zone d'émetteur (1) sont introduits, par implantation ionique sous masquage, à travers la surface de la zone de collecteur (4), puis diffusés, caractérisé en ce que:

— après la diffusion de la zone de collecteur (4) en atmosphère oxydante, les dopants de la zone de base et ceux de la zone d'émetteur (1) sont introduits successivement à travers ladite face, par implantation ionique sous masquage, puis la matière de masquage est enlevée et ladite face est recouverte d'une couche isolante d'origine allogène (5),

— ensuite, au cours d'un traitement thermique, les ions implantés sont activés, la zone de base (3) et la zone d'émetteur (1) se formant alors et la couche isolante d'origine allogène (5) étant consolidée, et

— enfin, des zones (1, 3, 4) sont localement mises à jour, au travers de la couche isolante (5), pour aménagement de contacts (6, 7, 8).

2. Procédé selon la revendication 1, caractérisé en ce que la diffusion de la zone de collecteur (4) a lieu dans une atmosphère légèrement oxydante, telle que l'agent dopant de la zone de base (3) puisse être implanté au travers de la même couche d'oxyde (13) que l'agent dopant de la zone d'émetteur (1).

3. Procédé selon l'une des revendications 1 ou 2, caractérisé en ce que l'agent dopant de la zone d'émetteur (1) est implanté à travers les ouvertures d'un masque d'implantation (9) qui présente, outre l'ouverture (10) d'implantation de la zone d'émetteur, une ouverture (11) entourant cette dernière (10), à la façon d'un cadre, cette ouverture (11) étant prévue pour l'implantation de l'agent dopant d'une zone (12) de contactage de collecteur, laquelle est en forme de cadre.

4. Procédé selon l'une des revendications 1 à 3, caractérisé en ce que l'on utilise exclusivement des masques en vernis photosensible pour délimiter l'implantation ionique des dopants de la zone de base (3) et de la zone d'émetteur (1).

FIG. 1

FIG. 2

FIG. 3

FIG. 4